(19) Europäisches Patentamt
European Patent Office
Office européen des brevets

(11) **EP 2 083 519 A2**

(12) **EUROPEAN PATENT APPLICATION**

(43) Date of publication:
**29.07.2009 Bulletin 2009/31**

(51) Int Cl.:
***H03M 13/11*** *(2006.01)*

(21) Application number: **09000796.4**

(22) Date of filing: **21.01.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **23.01.2008 JP 2008012946**

(71) Applicant: **Sony Corporation Tokyo 108-0075 (JP)**

(72) Inventor: **Yamagishi, Hiroyuki Tokyo 108-0075 (JP)**

(74) Representative: **Müller - Hoffmann & Partner Patentanwälte Innere Wiener Strasse 17 81667 München (DE)**

(54) **Decoding of low density parity check (LDPC) codes using quantized node operations with limited input range**

(57)     An LDPC decoding device wherein by limiting the input to the check node processing operation unit (54) to a range narrower than values that can be assumed by a received value as input (limiting a processing range), it is possible to simplify the operation of the function f (using a look-up table LUT) and the operations of the sum total, the subtraction, and the function f⁻¹ in the check node operation unit (54) with almost no degradation.

# FIG. 6

EP 2 083 519 A2

**Description**

CROSS REFERENCES TO RELATED APPLICATIONS

The present invention contains subject matter related to Japanese Patent Application JP 2008-012946 filed in the Japan Patent Office on January 23, 2008, the entire contents of which being incorporated herein by reference.

BACKGROUND OF THE INVENTION

1. Field of the Invention

The present invention relates to a device and a method for decoding, a program, and a recording medium, and particularly to a device and a method for decoding, a program, and a recording medium that make it possible to simplify operation involved in decoding.

2. Description of the Related Art

With recent remarkable progress of studies in, for example, a field of communication such as mobile communication and the like and a field of broadcasting such as terrestrial broadcasting, satellite digital broadcasting and the like, studies of coding theory have also been actively underway with an objective of improving efficiency of error correction coding and decoding.

A Shannon limit given by so-called Shannon (C. E. Shannon)'s channel coding theorem is known as a theoretical limit of code performance. Studies of coding theory are made with an objective of developing a code exhibiting performance close to the Shannon limit. Recently, low density parity check codes (hereinafter referred to as LDPC codes) as a coding method known from a long time ago have been attracting attention.

The LDPC code was first proposed by R. G. Gallager in "R. G. Gallager, 'Low-Density Parity-Check Codes,' IRE Transactions on Information Theory, 1962." Thereafter the LDPC code drew renewed attention in "D. J. C. MacKay, 'Good error correcting codes based on very sparse matrices,' Submitted to IEEE Trans. Inf. Theory, IT-45, pp. 399-431, 1999," "M. G. Luby, M. Mitzenmacher, M. A. Shokrollahi, and D. A. Spielman, 'Analysis of low density codes and improved designs using irregular graphs,' in Proceedings of ACM Symposium on Theory of Computing, pp. 249-258, 1998," and the like.

It is becoming known from recent studies that the LDPC code offers performance close to the Shannon limit as code length is increased.

SUMMARY OF THE INVENTION

In a case of decoding data coded by an LDPC code system, an amount of calculation involved in the decoding tends to increase because the decoding includes operation using a predetermined function and the like. However, reducing the amount of calculation enables even devices having low processing power to perform decoding, be reduced in cost, and shorten a processing time. There is thus a desire to reduce the amount of calculation at a time of the decoding.

The present invention has been made in view of such a situation. It is desirable to reduce an amount of calculation involved in decoding coded data.

According to an embodiment of the present invention, there is provided a decoding device for estimating an information word before being coded. In the decoding device, a processing range is limited to a range narrower than values that can be assumed by a value used as input to the decoding device, and decoding including a process of performing an operation referring to a look-up table associating a value within the limited range with an operation result when the value is substituted into a predetermined function is performed.

The decoding can be decoding based on an LDPC coding system.

The look-up table can be referred to when a message from a check node to a variable node is calculated.

When a message from a variable node to a check node is calculated, an operation of limiting a range of the message to be output can be performed.

According to an embodiment of the present invention, there is provided a decoding method of a decoding device for estimating an information word before being coded. The decoding method includes the steps of: limiting a processing range to a range narrower than values that can be assumed by a value used as input to the decoding device; and performing decoding including a process of performing an operation referring to a look-up table associating a value within the limited range with an operation result when the value is substituted into a predetermined function.

According to an embodiment of the present invention, there is provided a computer readable program for controlling decoding of a decoding device, the decoding device estimating an information word before being coded. In the program, a processing range is limited to a range narrower than values that can be assumed by a value used as input to the decoding device, and the decoding including a process of performing an operation referring to a look-up table associating a value within the limited range with an operation result when the value is substituted into a predetermined function is performed.

According to an embodiment of the present invention, there is provided a recording medium on which the program is recorded.

In a decoding device and method, a program, and a recording medium according to an embodiment of the present invention, a table associating a value limited to a range narrower than values that can be assumed by a value used as input to the decoding device with an operation result when the limited value is substituted into a predetermined function is referred to perform decoding.

According to an embodiment of the present invention, it is possible to reduce an amount of calculation involved in decoding.

BRIEF DESCRIPTION OF THE DRAWINGS

FIG. 1 is a diagram showing an example of an LDPC code decoding system;
FIG. 2 is a diagram showing an example of an LDPC code decoding system;
FIG. 3 is a bipartite graph corresponding to a parity check matrix;
FIG. 4 is a flowchart of assistance in explaining an LDPC code decoding algorithm;
FIG. 5 is a diagram showing a circuit configuration for LDPC code decoding;
FIG. 6 is a diagram showing a detailed configuration of a check node processing operation unit;
FIG. 7 is a diagram showing a detailed configuration of a variable node processing operation unit;
FIG. 8 is a diagram showing characteristics of bit error rates;
FIG. 9 is a diagram showing characteristics of bit error rates;
FIG. 10 is a diagram showing a detailed configuration of a variable node processing operation unit;
FIG. 11 is a diagram showing characteristics of bit error rates;
FIG. 12 is a diagram showing characteristics of bit error rates; and
FIG. 13 is a diagram of assistance in explaining recording media.

DETAILED DESCRIPTION OF THE PREFERRED EMBODIMENTS

Preferred embodiments of the present invention will hereinafter be described with reference to the drawings.

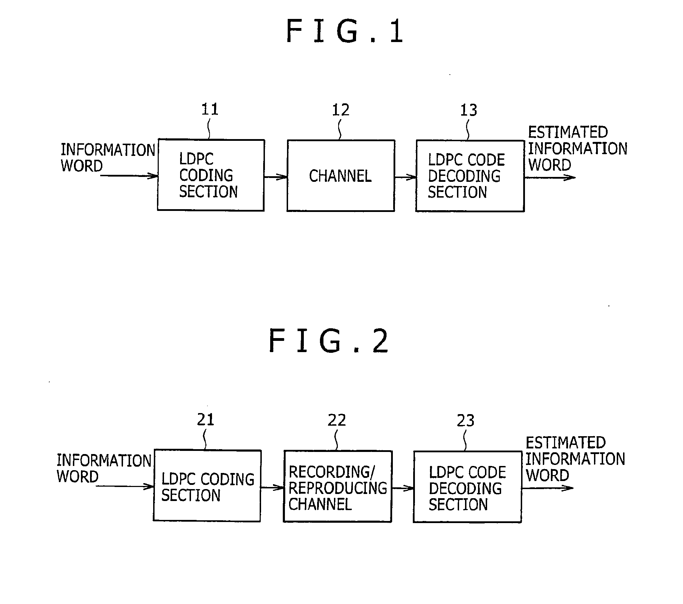

FIG. 1 is a diagram showing a configuration of an embodiment of a communication system using LDPC (Low Density Parity Check) codes. The communication system shown in FIG. 1 includes an LDPC coding section 11, a channel 12, and an LDPC code decoding section 13. The LDPC coding section 11 on a transmission side LDPC-encodes an information word, and then sends out the LDPC-encoded information word to the channel 12.

The LDPC code decoding section 13 on a reception side receives a signal including noise from the channel 12, estimates the information word by performing decoding based on the rule of the encoding performed on the transmission side (LDPC coding performed by the LDPC coding section 11 in this case), and then outputs the information word to a processing section in a subsequent stage not shown in FIG. 1.

In such a communication system, especially a communication system using turbo codes, LDPC codes or the like, iterative decoding using soft decision information is performed.

LDPC codes are not limited to communication systems as shown in FIG. 1, but are also applicable to recording and reproducing channels. FIG. 2 is a diagram showing a configuration of an embodiment of a recording and reproducing system using LDPC codes. The recording and reproducing system shown in FIG. 2 includes an LDPC coding section 21, a recording/reproducing channel 22, and an LDPC code decoding section 23.

At a time of recording, the LDPC coding section 21 LDPC-encodes an information word, and then records the LDPC-encoded information word on a recording medium. At a time of reproduction, the LDPC code decoding section 23 reads a signal including noise from the recording medium, estimates the information word by performing decoding based on the rule of the encoding performed at the time of the recording (LDPC coding performed by the LDPC coding section 21 in this case), and then outputs the information word to a processing section in a subsequent stage not shown in FIG. 2.

Description of the LDPC code will be added in the following. The LDPC code is a low density parity check code, and is a coding system presented by Robert G. Gallager in 1962. The LDPC code is a linear code characterized by a small number (low density) of non-zero elements in the parity check matrix of the LDPC code as compared with the total number of elements. It is known that the LDPC code exhibits an excellent bit error characteristic by iterative decoding, by being configured such that a short cycle is not included in the bipartite graph of the parity check matrix.

Generally, for a channel where noise and losses occur, an error correcting code is used to correctly estimate an information word on a reception side.

Letting H be a parity check matrix of M rows and N columns, an arbitrary codeword vector c of an LDPC code with a code length N satisfies

$$Hc = 0 \qquad \cdots \quad (1)$$

Equation (1) represents M parity check equations.

While the LDPC code is not particularly limited to a binary code, the following description will be limited to a binary code. However, this does not signify that the present invention to be described below is limited to binary codes.

The following Equation (2) is an example of the parity check matrix of an LDPC code.

$$H = \begin{pmatrix} 1 & 1 & 1 & 1 & 0 & 1 & 1 & 0 & 0 & 0 \\ 0 & 0 & 1 & 1 & 1 & 0 & 1 & 1 & 0 & 1 \\ 0 & 1 & 0 & 1 & 0 & 1 & 0 & 1 & 1 & 1 \\ 1 & 0 & 1 & 0 & 1 & 1 & 0 & 1 & 1 & 0 \\ 1 & 1 & 0 & 0 & 1 & 0 & 1 & 0 & 1 & 1 \end{pmatrix} \qquad \cdots \quad (2)$$

Each row of the parity check matrix represents a parity check equation, and each column of the parity check matrix corresponds to a code bit. It is known that the LDPC code can be decoded by a message-passing algorithm on the basis of the parity check matrix or the bipartite graph.

The bipartite graph corresponding to the parity check matrix of M rows and N columns includes M nodes corresponding to a check, N nodes corresponding to a variable, and edges connecting nodes to each other. An edge corresponds to the position of a non-zero element in the parity check matrix. Only when an element of an mth row and an nth column is not zero, an mth check node and an nth variable node are connected to each other by an edge, where m is an integer of zero or more and less than M, and n is an integer of zero or more and less than N.

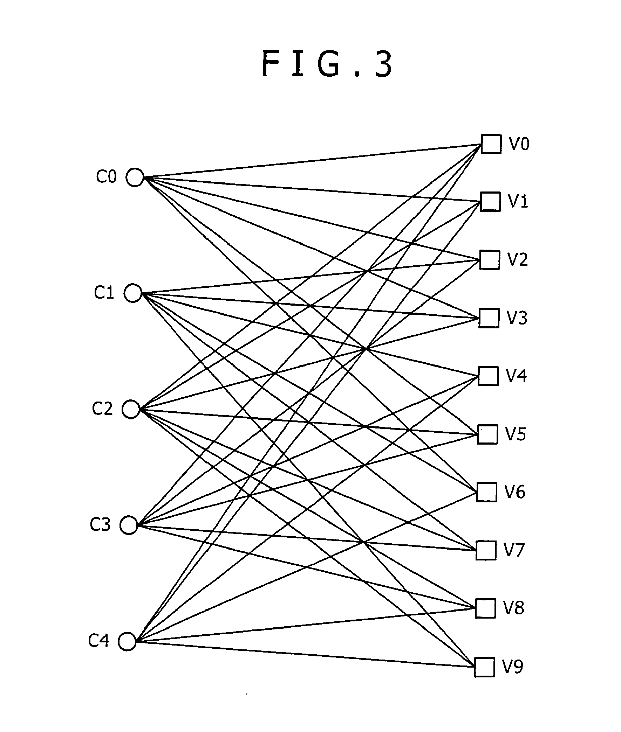

FIG. 3 is a bipartite graph corresponding to the parity check matrix H of Equation (2). In FIG. 3, circles denote check nodes C, and squares denote variable nodes V. The bipartite graph of FIG. 3 includes five check nodes C represented by the circles and ten variable nodes V represented by the squares.

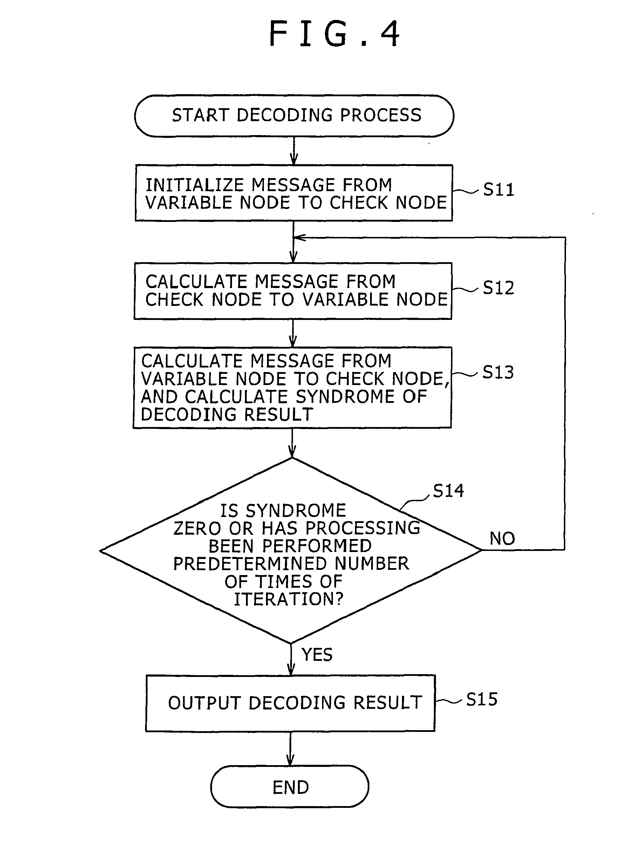

The decoding of an LDPC code by the message-passing algorithm is performed by propagating a message between nodes connected to each other by edges, and is performed by repeating a procedure as represented in a flowchart of FIG. 4.

In step S11, a message from a variable node to a check node is initialized. Specifically, a message $Q_{m, n}$ propagated from a variable node to a check node is initialized to a received value $P_n$ as an input to the decoding device. In the following, $P_n$ is treated as a logarithm likelihood ratio.

Incidentally, in the following, description of the "received value" will be made. However, the description does not signify that the present invention is applied to only received values. In other words, the description does not signify that the present invention is applied only when a value received via a channel 12 as shown in FIG. 1 is handled. For example, the present invention is, of course, applicable to cases of handling the value of a reproduced signal reproduced on a recording/reproducing channel 22 as shown in FIG. 2.

In step S12, a message from a check node to a variable node is calculated. This process updates a message $R_{m,n}$ propagated from a check node to a variable node by performing an operation based on the following Equation (3).

$$R_{m,n} = \left( \prod_{n' \in N(m) \backslash n} \alpha_{m,n'} \right) f^{-1} \left( \sum_{n' \in N(m) \backslash n} f(\beta_{m,n'}) \right) \qquad \cdots \quad (3)$$

In Equation (3), N(m) is a set of numbers of variable nodes connected to an mth check node, and $\alpha_{m,n}$ = sign $(Q_{m, n})$ and $\beta_{m, n} = |Q_{m, n}|$ are respectively the sign and the absolute value of $Q_{m,n}$. The function f is given by the following Equation (4).

$$f(x) = \ln \frac{e^x + 1}{e^x - 1} = -\ln \tanh(x/2) \qquad \cdots \quad (4)$$

In step S13, as a process at a variable node, a message from the variable node to a check node is calculated, and the syndrome of an estimated value of a codeword obtained by the hard decision of a decoding result is calculated. This calculation is performed by obtaining a posteriori logarithm likelihood ratio $Q_n$ by the following Equation (5).

$$Q_n = P_n + \sum_{m \in M(n)} R_{m,n} \qquad \cdots \quad (5)$$

In Equation (5), M(n) is a set of numbers of check nodes connected to an nth variable node. When iteration is further necessary, the message $Q_{m,n}$ propagated from the variable node to the check node is updated according to the following Equation (6).

$$Q_{m,n} = P_n + \sum_{m' \in M(n) \setminus m} R_{m',n} = Q_n - R_{m,n} \qquad \cdots \quad (6)$$

The decoding by the message-passing algorithm repeats the process of step S12 and step S13 until an ending condition is satisfied. A codeword is finally estimated by the hard decision of $Q_n$. In step S14, whether the iterative process is to be ended is determined. It is determined that the iteration is to be ended when a first condition or a second condition holds as follows.

First condition: Letting z be the estimated value of the codeword obtained by the hard decision of $Q_n$, the iteration is ended when the syndrome Hz is zero.

Second condition: The iteration is ended at a point in time when a preset number of iterations is reached.

When either the first condition or the second condition holds in step S14, the process proceeds to step S15, where a decoding result is output to the processing section not shown in the figures. When the LDPC code is a systematic code, the estimated value of the information word can be obtained by removing a part corresponding to the parity of the estimated codeword and extracting a part corresponding to the information word. When neither of the first condition and the second condition holds, the process returns to step S12 to repeat the process from step S12 on down.

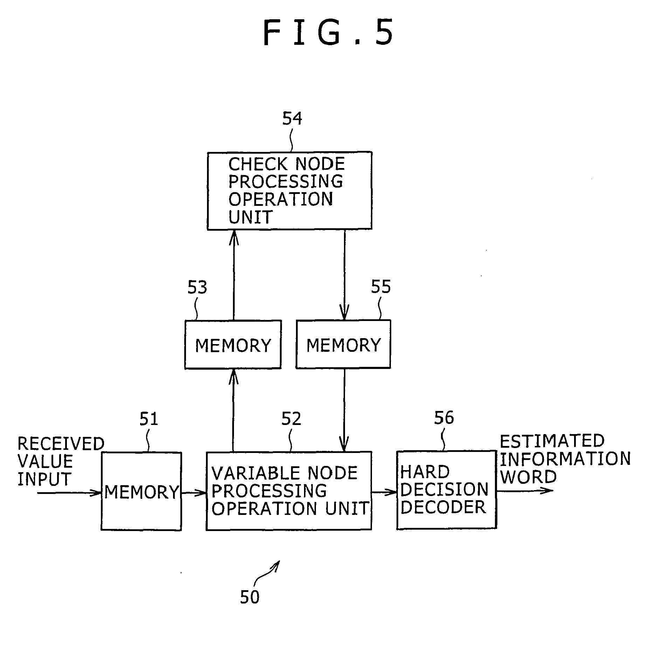

Description will be made of a configuration of a decoding device that performs such a process. FIG. 5 is a diagram showing a configuration of an embodiment of an LDPC code decoding device in the LDPC code. The LDPC code decoding device 50 shown in FIG. 5 includes a memory 51, a variable node processing operation unit 52, a memory 53, a check node processing operation unit 54, a memory 55, and a hard decision decoder 56.

The LDPC code decoding device 50 shown in FIG. 5 performs iterative decoding a plurality of times in the same device, but an initializing and iteration ending condition determining section is omitted from the configuration of the LDPC code decoding device 50 shown in FIG. 5. In addition, the following description will be made assuming a full parallel decoder that performs operation at all variable nodes and check nodes in parallel. However, there is a configuration in which operation at a plurality of nodes is processed by one or a plurality of operation units, and there is a configuration without the memory 51 or without the memory 53. The present invention is applicable to even such configurations, and thus the present invention is not limited to application to only the case of parallel operation. In addition, description will be continued supposing that a logarithm likelihood ratio and a message propagated between nodes are quantized and represented by a finite number of bits.

The memory 51 is supplied with a received value as an input to the decoding device, and temporarily stores the received value. The received value stored in the memory 51 is supplied to the variable node processing operation unit 52. The variable node processing operation unit 52 is a part that performs the process of step S13 in the flowchart of FIG. 4. The memory 53 temporarily stores data resulting from the process of the variable node processing operation unit 52, and then supplies the data to the check node processing operation unit 54.

The check node processing operation unit 54 is a part that performs the process of step S12 in the flowchart of FIG. 4. The memory 55 temporarily stores data resulting from the process of the check node processing operation unit 54, and then supplies the data to the variable node processing operation unit 52. An output from the variable node processing operation unit 52 is supplied to the hard decision decoder 56. An estimated codeword or an estimated information word is output from the hard decision decoder 56 to the processing section in the subsequent stage not shown in the figure.

A quantized received value $P_n$ is input to the LDPC code decoding device 50 shown in FIG. 5, and is temporarily stored in the memory 51. The variable node processing operation unit 52 that performs the process of step S13 and the check node processing operation unit 54 that performs the process of step S12 operate alternately, and a result of hard decision decoding is output.

In this case, suppose that the input $P_n$ to the LDPC code decoding device 50 is the value $P_n$ of a digital signal resulting from conversion by an A/D (Analog/Digital) converter, for example, and is quantized with a quantization step q and a number $2M_1$ of quantization levels. That is, suppose that the value y of a received value after the quantization is associated with a value x before the quantization by the following Equation (7).

$$y = LIMIT1(q(\lfloor x/q \rfloor + 0.5)) \qquad \cdots \ (7)$$

Here, LIMIT1 is a function for performing an operation that limits the output to a range indicated by the following Equation (8).

$$LIMIT1(a) = \begin{cases} -q(M_1 - 0.5), & a/q - 0.5 < -M_1 \\ a, & -M_1 \le a/q - 0.5 < M_1 \\ q(M_1 - 0.5), & M_1 \le a/q - 0.5 \end{cases} \qquad \cdots \ (8)$$

However, an integral value, rather than the value y itself, is easier to handle for a numerical representation within the LDPC code decoding device 50. For example, when the internal representation is y' = y/q - 0.5, y' assumes an integral value between $-M_1$ and $M_1 - 1$. Thus, such a representation can also be made so that processing can be performed using an integral value.

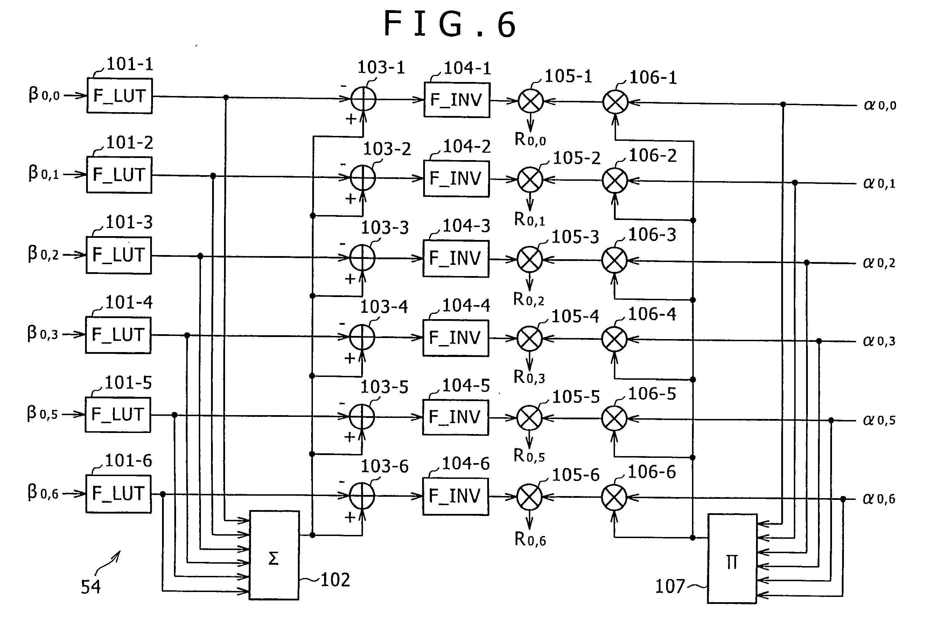

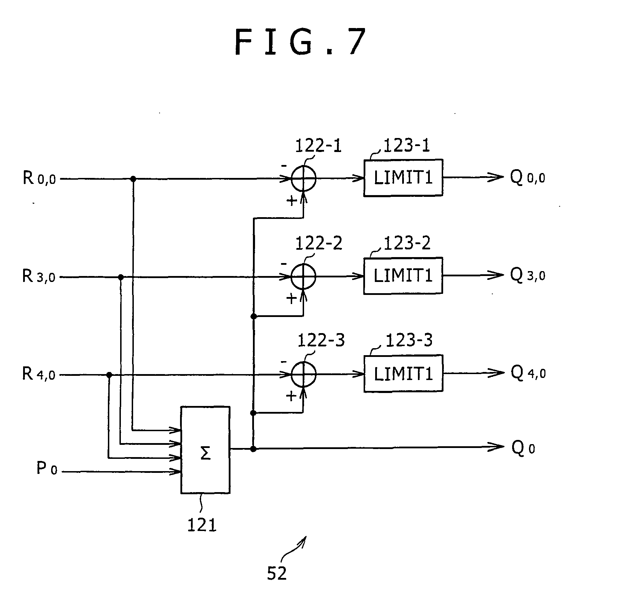

FIG. 6 is a block diagram of a check node processing operation unit 54 corresponding to the check node $C_0$ in the bipartite graph of FIG. 3. FIG. 7 is a block diagram of a variable node processing operation unit 52 corresponding to the variable node $V_0$ in the bipartite graph of FIG. 3.

The check node processing operation unit 54 in FIG. 5 includes a total of five circuit blocks similar to the check node processing operation unit 54 shown in FIG. 6. This is because, referring to FIG. 3, there are five check nodes $C_0$ to $C_4$. The variable node processing operation unit 52 in FIG. 5 includes a total of ten circuit blocks similar to the variable node processing operation unit 52 shown in FIG. 7. This is because, referring to FIG. 3, there are ten variable nodes $V_0$ to $V_9$.

The check node processing operation unit 54 shown in FIG. 6 has a configuration for performing an operation based on Equation (3). Specifically, the check node processing operation unit 54 shown in FIG. 6 includes: operation sections 101-1 to 101-6 for performing operation based on a predetermined function f; an operation section 102 for performing a sum total operation; subtracting sections 103-1 to 103-6 for subtracting one of two input values from the other; operation sections 104-1 to 104-6 for performing operation based on a predetermined function $f^{-1}$; multiplying sections 105-1 to 105-6 for multiplying two input values together; multiplying sections 106-1 to 106-6 for multiplying two input values together; and an operation section 107 for performing a product operation.

In FIG. 6, F_LUT denotes the operation corresponding to the function f, and F_INV denotes the operation corresponding to the function $f^{-1}$. The operation sections 101-1 to 101-6 respectively perform the operation corresponding to the function f on inputs $\beta_{0,0}$ o $\beta_{0,6}$. The operation sections 104-1 to 104-6 respectively perform the operation corresponding to the function $f^{-1}$ on outputs input from the corresponding subtracting sections 103-1 to 103-6.

In this case, when a value input to the operation sections 101-1 to 101-6 (when the operation sections 101-1 to 101-6 do not need to be individually distinguished from each other, the operation sections 101-1 to 101-6 will hereinafter be described as an operation section 101, and a similar description will be applied to other parts) is unknown, the operation based on the function f needs to be performed each time there is an input. However, when the input value can be assumed to some degree, a table associating the input value with a result of operation when the value is substituted into the function f can be prepared in advance, and the operation result can be output by referring to the prepared table.

That is, the operation of the function f can be implemented by referring to a look-up table (LUT) when the input is quantized to assume a finite number of values.

In addition, for the operation of the function $f^{-1}$, a comparison operation comparing an input with fixed values f (0.5q), f(1.5q), f(2.5q) and the like is performed, for example, and a configuration can be made such that zero is output when the input is f(0.5q) or more, and that kq is output when, with an integer k > 0, the input is f(q(k + 0.5)) or more and less than f (q (k - 0. 5)) .

The variable node processing operation unit 52 shown in FIG. 7 has a configuration for performing the operations of Equation (5) and Equation (6). Specifically, the variable node processing operation unit 52 shown in FIG. 7 includes: an operation section 121 for calculating a sum total of input values; subtracting sections 122-1 to 122-3 for subtracting one of two input values from the other; and operation sections 123-1 to 123-3 for performing a predetermined operation.

The operation sections 123-1 to 123-3 each perform the operation shown by Equation (8). Specifically, in this case, LIMIT1 performs the operation of Equation (8) on a result of the operation of Equation (6) so that a value referred to in F_LUT falls within a range between an upper limit and a lower limit determined by a constant $M_1$.

In general, when a difference between adjacent levels (quantization step) of numerical values after quantization is made finer and the number of quantization levels is increased, degradation in bit error rate (BER) due to the quantization is suppressed, and an excellent decoding characteristic is obtained. However, when the quantization step is made finer, the operation becomes complicated, and the device is increased in scale. On the other hand, when the quantization step is made larger and the number of quantization levels is decreased, the operation is simplified but the degradation due to the quantization is increased.

In the check node operation of the LDPC decoding, nonlinear conversion is performed by the function f and the function $f^{-1}$. Therefore, as the allowed range of an input value is wider, the check node processing operation unit 54 performs operation with higher accuracy, and a better decoding characteristic is obtained. On the other hand, as the allowed range of an input value is narrowed, the check node processing operation unit 54 performs operation with lower accuracy, and degradation due to quantization is increased.

Usually, the quantization step and the number of quantization levels are set such that the operation is not too complex within an allowable range of degradation due to quantization. For example, the quantization step and the number of quantization levels that can be represented by a minimum number of bits capable of achieving a bit error rate (BER) required at a specific signal to noise power ratio are selected.

A result of simulation when a concrete LDPC code is used is shown in the following. The LDPC code is a quasi-cyclic code with a code length of 2448 and an information bit length of 2312, and a matrix of 136 rows and 2448 columns as expressed by the following Equation (9) is used as a parity check matrix H.

$$H = [H_0 \quad H_1 \quad H_2 \quad \cdots \quad H_{135}] \qquad \qquad \cdots (9)$$

Here, each $H_j$ ($0 \le j$ j < 136) represent a small matrix of 136 rows and 18 columns. $H_0$ is represented by the following Equation (10). Incidentally, dots (.) in Equation (10) denote zero.

$$H_0^T =$$

$$\cdots \ (10)$$

In addition, an element of an sth row and a tth column ($0 \leq s < 136$, $0 \leq t < 18$) of $H_j$ ($0 < j < 136$) is equal to an element of an $(s + j)$ mod 136 row and a tth column, and the following Equation (11) is satisfied.

$$(H_j)_{s,t} = (H_0)_{(s+j)\bmod 136, t} \qquad \cdots \ (11)$$

The column weight of the parity check matrix H is 3, and the row weight of the parity check matrix H is 54. An LDPC code represented by such a parity check matrix H is a regular LDPC code.

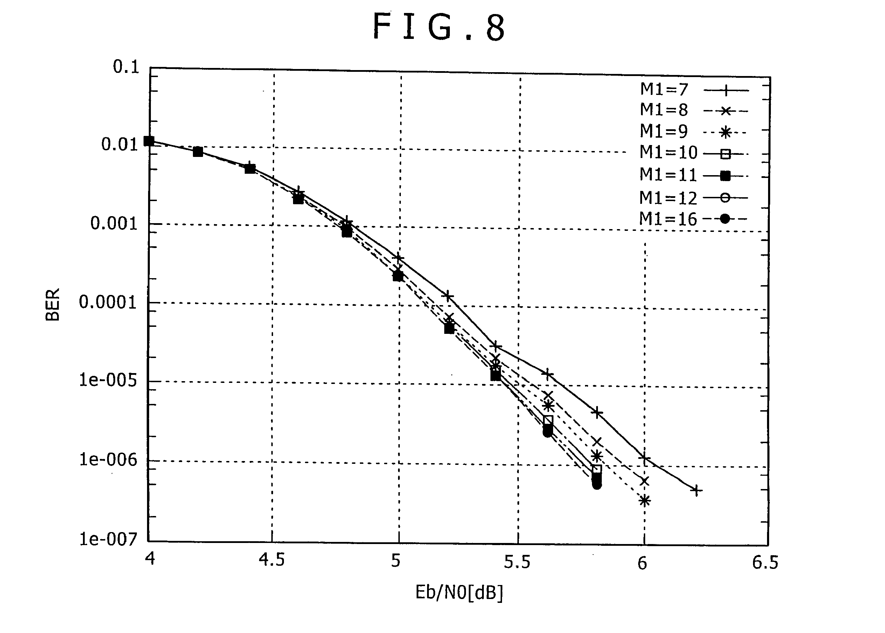

FIG. 8 is a graph showing BER characteristics after decoding in a BPSK white noise channel when a quantization step $q = 1$ and $M_1$ is 7, 8, 9, 10, 11, 12, and 16. In the graph of FIG. 8, an axis of abscissas indicates energy per information bit-to-noise power density (Eb/N0), and an axis of ordinates indicates a BER after the decoding. The iterative decoding is performed a maximum of 16 times.

The graph of FIG. 8 shows that the BER is degraded as the value of $M_1$ is decreased. However, the graph of FIG. 8 shows that when $M_1$ is a large value, for example $M_1 = 12$, degradation due to limitation of the range of input values is almost negligible.

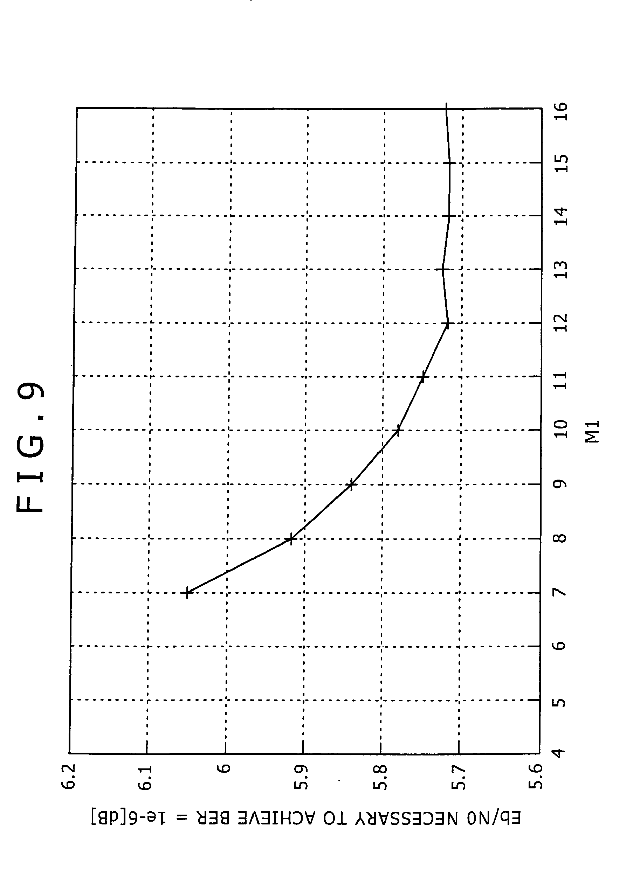

FIG. 9 is a graph obtained by determining and plotting the value of Eb/N0 at which the bit error rate BER = $10^{-6}$ for each value of $M_1$ from a simulation result. That is, in FIG. 9, the axis of abscissas indicates the value of $M_1$, and the axis of ordinates indicates the value of Eb/N0 necessary to achieve the bit error rate BER = $10^{-6}$.

The graph of FIG. 9 also shows that when $M_1$ is less than 12, the value of Eb/N0 necessary to achieve the bit error rate BER = $10^{-6}$ is increased as compared with the case of $M_1 = 16$, and BER performance is degraded, whereas when $M_1$ is 12 or more, substantially the same BER performance as in the case of $M_1 = 16$ can be obtained.

Table 1 shows F_LUT inputs and outputs (for example, values respectively input to and output from the operation sections 101-1 to 101-6 in FIG. 6) when $M_1 = 12$.

[Table 1]

| $\beta_{m,n}$ | $f(\beta_{m,n})$ | VALUE OBTAINED BY QUANTIZING FUNCTION OUTPUT |
|---|---|---|
| 0.5 | 1.406829 | 25545 |
| 1.5 | 0.453896 | 8242 |
| 2.5 | 0.164540 | 2988 |
| 3.5 | 0.060413 | 1097 |
| 4.5 | 0.022219 | 403 |
| 5.5 | 0.008174 | 148 |
| 6.5 | 0.003007 | 55 |
| 7.5 | 0.001106 | 20 |
| 8.5 | 0.000407 | 7 |
| 9.5 | 0.000150 | 3 |
| 10.5 | 5.51E-05 | 1 |
| 11.5 | 2.03E-05 | 0 |

When $M_1 = 12$, a message $Q_{m,n}$ from a variable node to a check node assumes 24 possible numerical values from -11.5 to 11.5, and the absolute value $\beta_{m,n}$ of the message $Q_{m,n}$ assumes 12 possible numerical values from 0.5 to 11.5. Because the number of F_LUT output bits which number is determined by the output dynamic range of the look-up table LUT shown in Table 1 is 15, the size of F_LUT is a capacity of 12 x 15 = 180 bits.

For example, when a received value and a message are both represented by 5 bits, conversion by the above-described function f associates each value of 4 bits of the absolute value part of a message with $2^4 = 16$ possible function values.

As another example, when a received value and a message are both represented by 6 bits, conversion by the above-described function f associates each value of 5 bits of the absolute value part of a message with $2^5 = 32$ possible function values.

The capacity of a look-up table LUT with an input of a bits and an output of b bits is a size of $2^a$ x b. The look-up table LUT may become more complex as the number $2^a$ of quantization levels of the input is increased, and as the bit accuracy b of the output is increased. Accordingly, the input to the check node processing operation unit 54 of the LDPC code decoding device 50 is limited to a range narrower than values that can be assumed by the decoding device input (received value), so that the operation of the check node processing operation unit 54 is simplified.

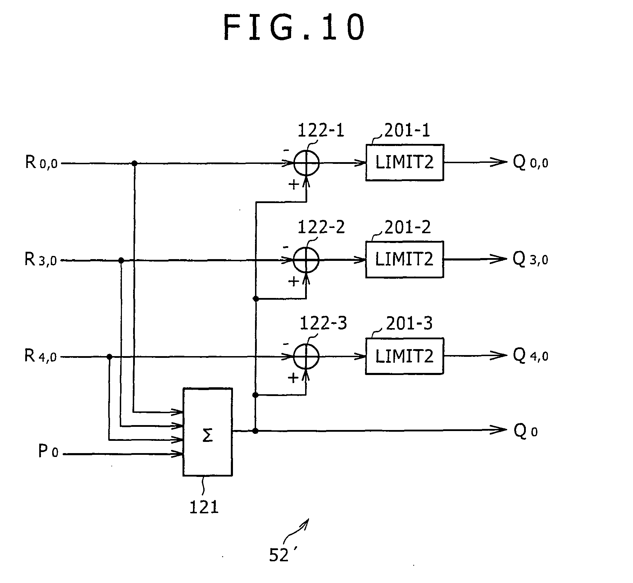

FIG. 10 is a block diagram of a variable node processing operation unit 52'. As compared with the variable node processing operation unit 52 shown in FIG. 7, the variable node processing operation unit 52' shown in FIG. 10 differs in that operation performed on a result of operation of Equation (6) is changed from LIMIT1 to LIMIT2. Specifically, the variable node processing operation unit 52' shown in FIG. 10 differs from the variable node processing operation unit 52 shown in FIG. 7 in that operation sections 201-1 to 201-3 are configured to perform the operation of LIMIT2. Otherwise the variable node processing operation unit 52' has a same configuration. The thus configured variable node processing operation unit 52' shown in FIG. 10 can be used in place of the variable node processing operation unit 52 of the LDPC code decoding device 50 shown in FIG. 5.

The operation of LIMIT2 performed in the operation section 201 has an integer $M_2$ as $M_2 < M_1$, and limits the output of the operation to a range of $-q(M_2 - 0.5)$ to $q(M_2 - 0.5)$. That is, the operation of the following Equation (12) is performed.

$$LIMIT2(a) = \begin{cases} -q(M_2 - 0.5), & a/q - 0.5 < -M_2 \\ a, & -M_2 \le a/q - 0.5 < M_2 \\ q(M_2 - 0.5), & M_2 \le a/q - 0.5 \end{cases} \quad \cdots \quad (12)$$

Because the number of values that can be assumed by the input of the function f is decreased from $M_1$ to $M_2$,

and because the dynamic range of a function output is reduced, a circuit necessary for the operation of the function f, for example, a LUT (look-up table) can be of a simple configuration. In addition, because the number of bits after conversion by the function f is decreased, the operations of the sum total, the subtraction, and the function $f^{-1}$ in the check node processing operation unit 54 can be simplified.

It will next be shown using simulation results that the limitation of $M_2 < M_1$ does not degrade BER performance when an appropriate $M_2$ is selected. As in the above-described case, an LDPC code used in decoding simulation is a quasi-cyclic code with a code length of 2448 and an information bit length of 2312, and a matrix of 136 rows and 2448 columns as expressed by Equation (9) is used as a parity check matrix H.

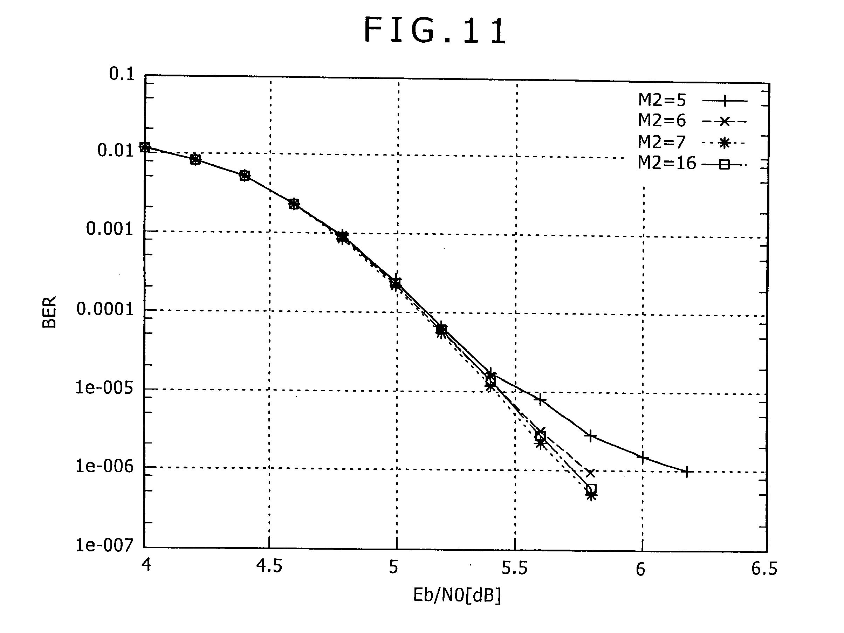

FIG. 11 is a graph showing BER characteristics after decoding in a BPSK white noise channel when a quantization step q = 1, $M_1$ = 16, and $M_2$ is 5, 6, 7, and 16 for the quantization of a received value input. $M_2$ = 16 is the same as $M_1$ = 16 in a decoding method when the above-described variable node processing operation unit 52 is used.

It can be read from the graph of FIG. 11 that although a BER is degraded when $M_2$ is a value of six or less, degradation due to the limitation of a range of F_LUT input values does not occur when $M_2$ is seven.

Table 2 shows F_LUT inputs and outputs when $M_2$ = 7.

[Table 2]

| $\beta_{m,n}$ | $f(\beta_{m,n})$ | VALUE OBTAINED BY QUANTIZING FUNCTION OUTPUT |
|---|---|---|
| 0.5 | 1.406829 | 172 |
| 1.5 | 0.453896 | 56 |
| 2.5 | 0.164540 | 20 |
| 3.5 | 0.060413 | 7 |
| 4.5 | 0.022219 | 3 |
| 5.5 | 0.008174 | 1 |
| 6.5 | 0.003007 | 0 |

When $M_2$ = 7, a message $Q_{m,n}$ from a variable node to a check node assumes 14 possible numerical values from -6.5 to 6.5, and the absolute value $\beta_{m,n}$ of the message $Q_{m,n}$ assumes seven possible numerical values from 0.5 to 6.5. Because the number of F_LUT output bits which number is determined by the output dynamic range of the look-up table LUT shown in Table 2 is eight, the size of F_LUT is a capacity of 7 x 8 = 56 bits. This represents a reduction of about 69% as compared with the capacity of F_LUT in the above-described case of $M_1$ = 12.

In addition, the number of bits of input for the sum total, the subtraction, and the function $f^{-1}$ in the check node processing operation unit 54 is smaller than in the case of $M_1 = M_2$ = 12, so that the operations can be simplified.

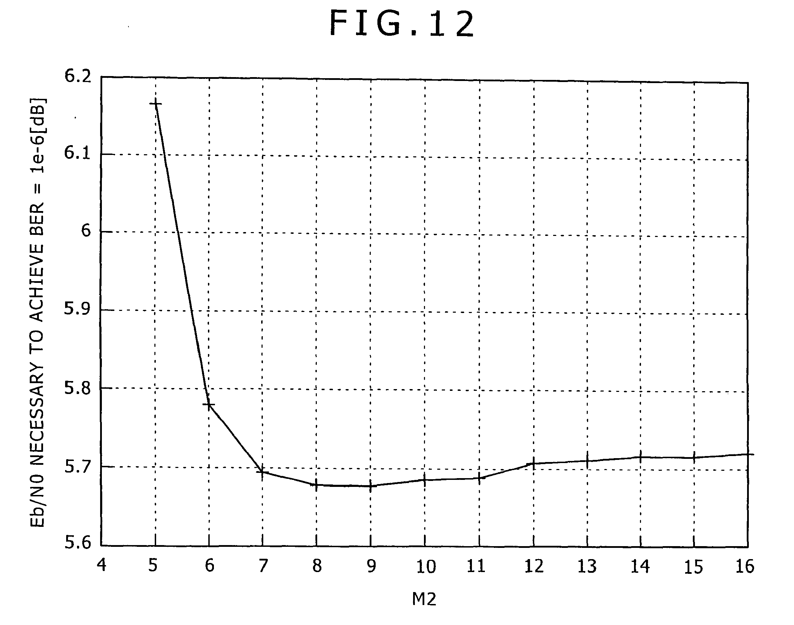

FIG. 12 is a graph obtained by determining and plotting the value of Eb/N0 at which the bit error rate BER = $10^{-6}$ for each value of $M_2$ from a simulation result. That is, in FIG. 12, the axis of abscissas indicates the value of $M_2$, and the axis of ordinates indicates the value of Eb/N0 necessary to achieve the bit error rate BER = $10^{-6}$.

The graph of FIG. 12 shows that when $M_2$ is less than seven, the value of Eb/N0 necessary to achieve the bit error rate BER = $10^{-6}$ is increased as compared with the case of $M_2$ = 16. However, it is shown that when $M_2$ is seven or more and less than 16, the bit error rate BER = $10^{-6}$ can be achieved even with a slightly smaller value of Eb/N0 than in the case of $M_2$ = 16.

In operation at a check node in a process of ordinary LDPC decoding, the operation of the following Equation (13) in Equation (3) is performed.

$$f^{-1}\left( \sum_{n' \in N(m) \backslash n} f(\beta_{m,n'}) \right) \qquad \cdots \quad (13)$$

The operation expressed by this Equation (13) provides a value smaller than a minimum value of $\beta_{m,n'} = |Q_{m,n'}|$. That is, even when the absolute values (magnitude of reliability) of messages $Q_{m,n}$ from variable nodes to the check node are all large values, the absolute value (magnitude of reliability) of a message $R_{m,n}$ from the check node to a variable node which message is obtained by Equation (3) is smaller than the absolute values of the messages $Q_{m,n}$.

If the absolute values $\beta_{m,n'} = |Q_{m,n'}|$ are all 6.5, because the column weight of the parity check matrix H is 54, the absolute value of the message $R_{m,n}$ is a value shown in the following Equation (14), which value represents a very low reliability as compared with $\beta_{m, n}' = |Q_{m, n'}| = 6.5$.

$$f^{-1}\left(53 \times f(6.5)\right) = 2.5318 \qquad \cdots \quad (14)$$

On the other hand, in the LUT defined in Table 2, the value of the function f corresponding to $\beta_{m, n'} = |Q_{m, n'}|$ I = 6.5 is set at zero. Therefore F_INV when the absolute values $\beta_{m, n'} = |Q_{m, n'}|$ I are all 6.5 outputs six. Hence, the effect of suppressing a decrease in reliability even when reliability from a variable node to a check node is a large value improves BER characteristics as compared with the case of $M_2 = 16$.

By thus limiting the input to the check node processing operation unit 54 to a range narrower than values that can be assumed by a received value as input to the LDPC code decoding device 50 (limiting a processing range), it is possible to simplify the operation of the function f and the operations of the sum total, the subtraction, and the function $f^{-1}$ in the check node processing operation unit 54 with almost no degradation in decoding performance.

The series of processes described above including, for example, the process of converting an input value to an output value referring to a LUT can be carried out not only by hardware but also by software. When the series of processes is to be carried out by software, a program constituting the software is installed from a program recording medium onto a computer incorporated in dedicated hardware, or a general-purpose personal computer, for example, that can perform various functions by installing various programs thereon.

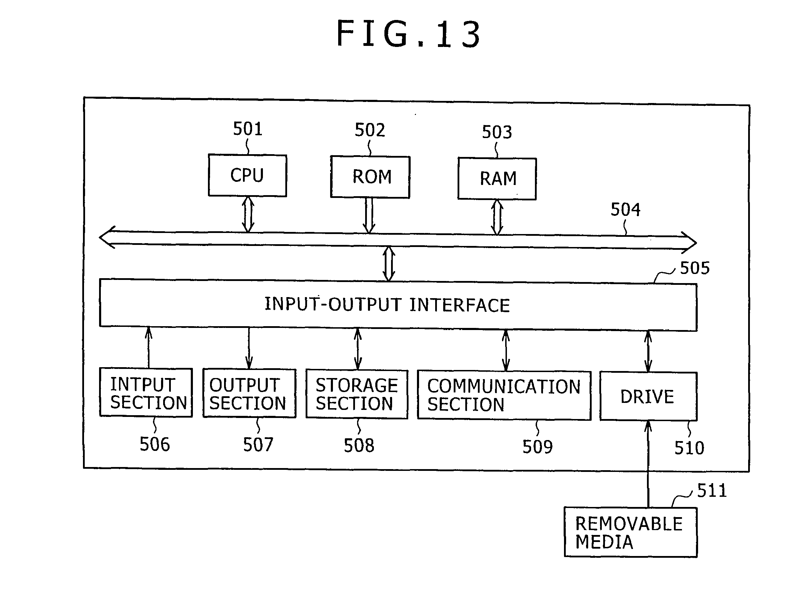

FIG. 13 is a block diagram showing an example of configuration of hardware of a personal computer that performs the series of processes described above by program.

In the computer, a CPU (Central Processing Unit) 501, a ROM (Read Only Memory) 502, and a RAM (Random Access Memory) 503 are interconnected by a bus 504.

The bus 504 is further connected with an input-output interface 505. The input-output interface 505 is connected with an inputting section 506 formed by a keyboard, a mouse, a microphone and the like, an outputting section 507 formed by a display, a speaker and the like, a storing section 508 formed by a hard disk, a nonvolatile memory and the like, a communicating section 509 formed by a network interface and the like, and a drive 510 for driving removable media 511 such as a magnetic disk, an optical disk, a magneto-optical disk, a semiconductor memory or the like.

In the computer configured as described above, the CPU 501, for example, loads a program stored in the storing section 508 into the RAM 503 via the input-output interface 505 and the bus 504, and then executes the program, whereby the series of processes described above is performed.

The program executed by the computer (CPU 501) is, for example, provided in a state of being recorded on the removable media 511, which are packaged media formed by a magnetic disk (including flexible disks), an optical disk (CD-ROM (Compact Disk-Read Only Memory), DVD (Digital Versatile Disk) and the like), a magneto-optical disk, a semiconductor memory or the like, or provided via a wire or wireless transmission medium such as a local area network, the Internet, digital satellite broadcasting or the like.

Then, by mounting the removable media 511 in the drive 510, the program can be installed into the storing section 508 via the input-output interface 505. The program can also be received by the communicating section 509 via the wire or wireless transmission medium and then installed into the storing section 508. In addition, the program can be installed into the ROM 502 or the storing section 508 in advance.

Incidentally, the program executed by the computer may perform processing in time series in the order described in the present specification, or may perform processing in parallel or in necessary timing such, for example, as when a call is made.

In addition, in the present specification, a system refers to an apparatus as a whole formed by a plurality of devices.

It should be understood by those skilled in the art that various modifications, combinations, subcombinations and alterations may occur depending on design requirements and other factors insofar as they are within the scope of the appended claims or the equivalents thereof.

**Claims**

1. A decoding device for estimating an information word before being coded,
   wherein a processing range is limited to a range narrower than values that can be assumed by a value used as input to said decoding device, and decoding including a process of performing an operation referring to a look-up table associating a value within the limited range with an operation result when the value is substituted into a predetermined function is performed.

**2.** The decoding device according to claim 1,
wherein said decoding is decoding based on a low density parity check coding system.

**3.** The decoding device according to claim 2,
wherein said look-up table is referred to when a message from a check node to a variable node is calculated.

**4.** The decoding device according to claim 2,
wherein when a message from a variable node to a check node is calculated, an operation of limiting a range of said message to be output is performed.

**5.** A decoding method of a decoding device for estimating an information word before being coded, the method comprising the steps of:

limiting a processing range to a range narrower than values that can be assumed by a value used as input to said decoding device; and
performing decoding including a process of performing an operation referring to a look-up table associating a value within the limited range with an operation result when the value is substituted into a predetermined function.

**6.** A computer readable program for controlling decoding of a decoding device, said decoding device estimating an information word before being coded,
wherein a processing range is limited to a range narrower than values that can be assumed by a value used as input to said decoding device, and the decoding including a process of performing an operation referring to a look-up table associating a value within the limited range with an operation result when the value is substituted into a predetermined function is performed.

**7.** A recording medium on which a computer readable program for controlling decoding of a decoding device is recorded, said decoding device estimating an information word before being coded,
wherein a processing range is limited to a range narrower than values that can be assumed by a value used as input to said decoding device, and the decoding including a process of performing an operation referring to a look-up table associating a value within the limited range with an operation result when the value is substituted into a predetermined function is performed.

# F I G . 1

```
           11              12              13
    _____      _____      _____     ESTIMATED
INFORMATION |  LDPC   |    |         |    |  LDPC CODE |  INFORMATION
WORD ────►  | CODING  │──► | CHANNEL │──► | DECODING   │  WORD ───►
            | SECTION |    |         |    |  SECTION   |
            ‾‾‾‾‾‾‾‾‾‾‾    ‾‾‾‾‾‾‾‾‾‾‾    ‾‾‾‾‾‾‾‾‾‾‾
```

# F I G . 2

```
           21              22              23
    _____      _____      _____     ESTIMATED
INFORMATION | LDPC CODING |  | RECORDING/  |  | LDPC CODE  |  INFORMATION
WORD ────►  | SECTION     │──► REPRODUCING │──► DECODING   │  WORD ───►
            |             |  | CHANNEL     |  | SECTION    |
            ‾‾‾‾‾‾‾‾‾‾‾‾‾‾    ‾‾‾‾‾‾‾‾‾‾‾‾‾    ‾‾‾‾‾‾‾‾‾‾‾‾
```

# FIG.3

# F I G . 4

```
   ┌─────────────────────────────┐
   │   START DECODING PROCESS    │
   └─────────────────────────────┘
                 │
                 ▼
   ┌─────────────────────────────┐
   │ INITIALIZE MESSAGE FROM     │ ～S11
   │ VARIABLE NODE TO CHECK NODE │
   └─────────────────────────────┘
                 │
                 ▼ ◄──────────────────────────┐
   ┌─────────────────────────────┐            │
   │ CALCULATE MESSAGE FROM      │ ～S12       │
   │ CHECK NODE TO VARIABLE NODE │            │
   └─────────────────────────────┘            │
                 │                            │
                 ▼                            │
   ┌─────────────────────────────┐            │
   │ CALCULATE MESSAGE FROM      │ ～S13       │
   │ VARIABLE NODE TO CHECK NODE,│            │
   │ AND CALCULATE SYNDROME OF   │            │
   │ DECODING RESULT             │            │
   └─────────────────────────────┘            │
                 │                            │
                 ▼                            │
              ◇ S14                           │
         IS SYNDROME                          │
       ZERO OR HAS PROCESSING        NO       │
         BEEN PERFORMED     ─────────────────┘
      PREDETERMINED NUMBER
           OF TIMES OF
           ITERATION?
                 │
                 │ YES
                 ▼
   ┌─────────────────────────────┐
   │  OUTPUT DECODING RESULT     │ ～S15
   └─────────────────────────────┘
                 │
                 ▼
   ┌─────────────────────────────┐
   │            END              │
   └─────────────────────────────┘
```

# FIG.5

54

CHECK NODE
PROCESSING
OPERATION
UNIT

53

MEMORY

55

MEMORY

RECEIVED
VALUE
INPUT

51

MEMORY

52

VARIABLE NODE
PROCESSING
OPERATION UNIT

56

HARD
DECISION
DECODER

ESTIMATED
INFORMATION
WORD

50

FIG.6

# FIG.7

52

F I G . 8

BER vs Eb/N0[dB]

Legend: M1=7, M1=8, M1=9, M1=10, M1=11, M1=12, M1=16

# FIG.9

EP 2 083 519 A2

# FIG.10

# FIG.11

EP 2 083 519 A2

FIG.12

# FIG.13

EP 2 083 519 A2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008012946 A

**Non-patent literature cited in the description**

- **R. G. Gallager.** Low-Density Parity-Check Codes. *IRE Transactions on Information Theory,* 1962
- **D. J. C. MacKay.** Good error correcting codes based on very sparse matrices. *IEEE Trans. Inf. Theory,* 1999, vol. IT-45, 399-431
- **M. G. Luby ; M. Mitzenmacher ; M. A. Shokrollahi ; D. A. Spielman.** Analysis of low density codes and improved designs using irregular graphs. *Proceedings of ACM Symposium on Theory of Computing,* 1998, 249-258